# EUROPÄISCHE PATENTANMELDUNG

(11) **EP 4 685 585 A1**
(43) Veröffentlichungstag der Anmeldung: **28.01.2026**
(21) Anmeldenummer: 24190318.6
(22) Anmeldetag: 23.07.2024
(51) Int. Cl.: G05B 17/02, G06F 30/20, G06F 40/10, G06F 40/30, G06N 5/025, G05B 19/418

(54) **VERFAHREN ZUR BEREITSTELLUNG VON SIMULATIONSDATEN FÜR EINE INDUSTRIELLE ANLAGE**

(71) Anmelder: Siemens Aktiengesellschaft, 80333 München (DE)
(72) Erfinder: Mayer, Hermann Georg, 83209 Prien am Chiemsee (DE)
(74) Vertreter: Siemens Patent Attorneys

(57) **Zusammenfassung**

Industrielle Prozesse rund um diese Industrieanlage umfassen typischerweise zahlreiche, miteinander logisch verbundene Prozessschritte und zeichnen sich durch eine hohe Komplexität bezüglich der beteiligten Assets und zur Anwendung kommenden Prozesse aus, sowohl zum Betreiben der Anlage als auch bei Aufbau und Wartung aus.

In der Regel wurden neue Daten- und Simulationsmodelle auf der Basis existierender Lösungen und der Hinzunahme neuer Anforderungen erstellt.

Es ist daher Aufgabe der Erfindung, ein automatisches System vorzuschlagen, mit dem die vom LLM erzeugte, textuelle Information schrittweise verfeinert und ergänzt werden, um automatisch daraus ein Simulationsmodell zu generieren.

Ein geeignetes Mittel zur Lösung sind Standards oder genauer gesagt die Ontologien, die in vielen Standards wie IFC, DEXPI enthalten sind.

## Beschreibung

Eine Industrieanlage ist ein komplexes System bestehend aus verschiedenen Assets, wie Bearbeitungsmaschinen, Transportvorrichtungen, Messgeräten, Steuerungsprogrammen und vieles mehr, zur Realisierung von industriellen Prozessen. Die industriellen Prozesse rund um diese Industrieanlage umfassen typischerweise zahlreiche, miteinander logisch verbundene Prozessschritte und zeichnen sich durch eine hohe Komplexität bezüglich der beteiligten Assets und zur Anwendung kommenden Prozesse aus, sowohl zum Betreiben der Anlage als auch bei Aufbau und Wartung aus.

Ein Datenmodell im Allgemeinen ist eine Spezifikation von Datenstrukturen, das wiederum aus verschiedenen Datenelementen besteht. Es veranschaulicht, wie verschiedene Datenelemente zueinander in Beziehung stehen. Wenn ein Datenmodell in einem industriellen Prozess angewendet wird, kann es beispielsweise Angaben darüber liefern, von wem ein Auftrag getätigt wurde, was beauftragt wurde und wann. Das Modell kann Daten über Kunden, Produkt, Geschäft, Verkäufer, Hersteller, Lieferkette, Details zu den Assets, ihrer Einsatzgebiete und vieles mehr enthalten.

Datenmodelle können dabei verschiedene Ausprägungen aufweisen:
- konzeptionelle Datenmodelle, auch Domänenmodelle genannt, untersuchen statische Strukturen und Konzepte, eine Vorstufe zu
- Logische Datenmodellen, zur Verdeutlichung logischer Typen oder Klassen von Daten, und zugehörigen Datenattributen und Beziehungen, und
- Physische Datenmodelle, welche den konkreten Aufbau der Anlage repräsentieren.

Zusätzliche Simulations- und Trainingsmodelle bieten darüber hinaus die Möglichkeit, komplizierte, technische Anlagen realistisch darzustellen und ermöglichen eine perfekte Simulation, so dass die Anlage und die darin ablaufenden industriellen Prozesse für jedermann begreifbar werden.

Der Datenfluss bezeichnet bislang die eigentliche Kommunikation in der Anlage. Inzwischen gibt es üblicherweise darüber hinaus einen sogenannten "Digitalen Zwilling", also ein digitales Abbild der vorhandenen Assets in der realen Industrieanlage und erlaubt die Simulation, Steuerung und Verbesserung der industriellen Prozesse und des Einsatzes der Assets für das geplante Ziel. Viele Aspekte der Fabrik können für und durch eine Simulation abgebildet werden, beispielsweise
- Modellbasierte Selbstbeschreibungen von Maschinen, den zugehörigen Treibern für die Identifikation und Konfiguration, mit Treibern im Fertigungssteuerungssystem (Manufacturing Execution System, MES)
- Die Beschreibung der Fähigkeiten (Skills) der Assets, beispielsweise der angebotenen Fertigungsverfahren, oder Materialflußfunktionen, und deren zulässige Wertebereiche
- Modelle des Normalverhaltens einer Maschine, beispielsweise basierend auf Laufzeitdaten, Stromverbrauch, Wartungsintervalle, Lebensdauer etc.

Datenmodelle und Simulationsmodelle sind meist proprietär und müssen daher häufig zwischen verschiedenen Formaten konvertiert werden. Im Verlauf ihres Lebenszyklus werden sie durch mehrere Softwarekomponenten bearbeitet, die ihrerseits wiederum auf unterschiedlichen Datenmodellen basieren. Eines dieser Tools ist beispielsweise ein Fertigungssteuerungssystem (MES). Darunter versteht man ein Softwaresystem, das den Prozess der Herstellung von Waren vom Rohmaterial bis zum fertigen Produkt überwacht, verfolgt, dokumentiert und steuert. Als funktionale Ebene zwischen der Ressourcen-Planung (ERP, Enterprise Resource Planning) und den Prozesssteuerungssystemen liefert das Fertigungssteuerungssystem die Daten, die benötigt werden, um die Produktion effizienter zu gestalten und zu optimieren.

Dies umfasst auch implizite Modelle, die durch text-basierte Anforderungen ("Requirements") beschrieben werden und daher zunächst über einen Modell-Editor in eine explizite Form gebracht werden müssen.

Durch disziplinübergreifendes Arbeiten und durch die steigende Komplexität und Realitätstreue von Modellen hat sich diese Herausforderung in letzter Zeit verschärft. Integrationsbemühungen wie die Verabschiedung von Standards und die Erhöhung von Interoperabilität von Softwarekomponenten können mit dem steigenden Bedarf nicht mithalten.

In der Regel wurden neue Daten- und Simulationsmodelle auf der Basis existierender Lösungen und der Hinzunahme neuer Anforderungen erstellt. Nur im seltenen Fall einer komplett neuen Lösung werden auch (oder nur) die Anforderungen (Requirements) verwendet.

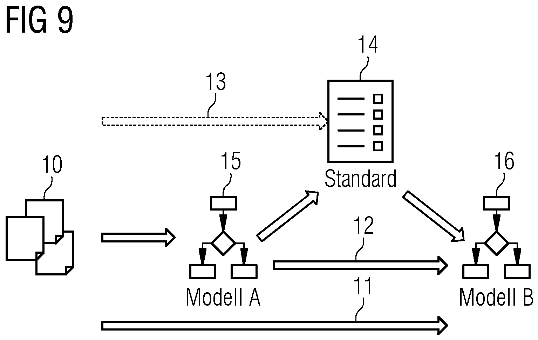

Figur 9 zeigt einen Ablauf wie er im Stand der Technik bekannt ist. Üblicherweise wurde aus den Anforderungen 10 (und weiteren Daten) zunächst ein Modell A, 15, erstellt, dass die beschriebenen Anforderungen erfüllt. Wurde danach die Hinzunahme oder der Austausch von Softwarekomponenten nötig (z. B. für die Übergabe der erzeugten Software an einen Kunden), so wurde häufig das Daten- / Simulationsmodell für diese Komponente noch einmal von vorne, aus den ursprünglichen Anforderungen erzeugt. Alternativ wurde das bereits bestehende Modell A in ein Zielmodell Modell B, 16 umgewandelt, sofern dies möglich war bzw. von Software A mittels eines Exports unterstützt wurde, 12. Eine Neuerstellung ist in der Regel mit einem hohen, insbesondere auch manuellen Aufwand verbunden, während der Export die Implementierung spezieller 1:1 Anbindungen (Simulator A an Simulator B) erfordert.

Zur Vereinfachung dieser wiederkehrenden Aufgaben wurde als dritte Variante die Verabschiedung von Industriestandards 14 angestrebt, die die Bedürfnisse möglichst vieler Hersteller abdecken. Standards werden in der Regel dadurch umgesetzt, dass eine der beteiligten Softwarekomponenten (z. B. ein Simulator von Modell A) Modelle exportieren kann, die dem Standard entsprechen und dann von anderen Komponenten eingelesen werden können. Oder es wird von vorneherein ein Modell entworfen, dass dem Standard bereits entspricht, 13. Der Einsatz eines Standards ist im Allgemeinen zunächst mit weiterem Zusatzaufwand verbunden, der sich aber umso schneller amortisiert, je mehr Transformationen während des Lebenszyklus durchgeführt werden müssen. Beispiele für derartigen Standards sind "Industry Foundation Classes" IFC für den Datenaustausch in der Baubranche und "Data Exchange in the Process Industry" DEXPI, die den Datenaustausch in der Prozessindustrie beschreiben.

Standards bieten viele der oben genannten Vorteile, allerdings gibt es auch einige Nachteile. So dauert es in der Regel lange, bis neue Versionen von Standards verabschiedet werden und sich diese dann auch bei den Herstellern durchsetzen (z. B. ist bei IFC ein Durchschnitt von ca. 10 Jahren zu beobachten: die Arbeit am Standard begann ca. im Jahr 2000, erst 10 Jahre später gab es eine breitere Unterstützung durch Hersteller von IFC2x3, und erst seit 2020 die Unterstützung von IFC4). Nicht nur deswegen sind Standards unflexibel bzgl. ihrer Anpassung an neue Anforderungen.

Auch eine Übernahme von Standards in neue Tätigkeitsfelder ist meist schwierig (beispielsweise die Anwendung von IFC auf Industriegebäude, oder die Anwendung von DEXPI auf (HVAC) Anlagen in Wohngebäuden). Standards können zudem oft nicht alle Spezialfälle oder Besonderheiten von Modellen bestimmter Hersteller abdecken.

In einem Ausführungs-Beispiel wird ein Modell zusammen mit einer zusätzlichen Beschreibung (Requirements) zunächst in den DEXPI-Standard umgewandelt:
Der Code ist aus einem proprietären Programm, das in einem sehr einfachen Beispiel die Verbindung einer Pumpe "B" mit zwei Gefäßen "A" und "C" zeigt. Aufgabe ist die Konvertierung in einen String im DEXPI Format für P&ID Diagramme (R&I Fließschema, piping and instrumentation diagram).

Gegeben ist also die folgende Punktfolge

```
"digraph G{
A -> B -> C
}
```

Eine mögliche generierte Beschreibung des Systems, welches durch die Punktfolge repräsentiert ist, könnte dann so lauten:
"Dieses System besteht aus drei Komponenten: 2 Behältern, bezeichnet mit "A" und "C", und einer Pumpe, bezeichnet mit "B". Die Pumpe ist mit den beiden Behältern verbunden, mit einem Pfeil von "A" nach "B" und einem weiteren Pfeil von "B" nach "C".

Das legt nahe, dass die Pumpe verwendet wird, um Flüssigkeiten oder anderes Material von einem ersten Behälter in einen weiteren Behälter zu transferieren. Die Richtung der Pfeile indiziert dabei, dass der Fluß unidirektional ist, von "A" nach "C" über "B"."

Aus dieser Beschreibung kann dann beispielsweise ein Modelica Modell (Modelica ist eine objektorientierte Programmiersprache für physikalische Modelle) generiert werden. Alternativ kann das Modell aus dieser Beschreibung oder aus dem DEXPI File generiert werden.

Die Information wird jeweils in eine textuelle Beschreibung verwandelt. Danach werden die Repräsentationen unabhängig voneinander in das Zielformat gebracht.

In beiden Fällen wurde bei Tests ein Modell erzeugt, das von Modelica geladen werden kann, musste aber jeweils manuell nachbearbeitet werden, um funktionsfähig zu sein.

Diese Ausgabe kann beispielsweise durch ein LLM wie das bereits bekannte ChatGPT erzeugt werden. Das hier verwendete Ausgangsmodell sehr einfach (drei seriell verbundene Komponenten Tank - Pumpe - Tank). Es ist zu erwarten, dass sich die Qualität der Ausgabe mit zukünftigen (immer größeren) LLMs verbessern wird, eine funktionierende Lösung, die eine Nachbearbeitung unnötig macht, ist auch für komplexe Modelle aber erst einmal nicht zu erwarten. Dies liegt unter anderem daran, dass Standards und Modelle oft eine Sprache benutzen, deren Charakteristik sich deutlich von natürlichen Sprachen unterscheidet (insbesondere das distanzunabhängige Referenzieren von Kontext und die Benutzung von Klammerstrukturen). Zudem ist in manchen Standards und Modellen auch die Topologie und Geometrie vermischt. Topologie kann von Sprachmodellen besser bewältigt werden als Geometrie. Schließlich ist die Anzahl von Trainingsbeispielen für industrielle Anwendungen begrenzt, sodass auch immer größere Sprachmodelle keinen zusätzlichen Vorteil bieten.

Es hat sich gezeigt, dass LLMs häufig schon das gesamte nötige Wissen zur Erstellung eines Simulationsmodells beinhalten, dieses aber gezielt aktiviert werden muss. So führt die allgemeine Frage "Gib mir alle Komponenten aus der Anforderungsbeschreibung (Requirements) und ihre Verbindungen zueinander" in der Regel zu einer unvollständigen textuellen Beschreibung, die falsche Verbindungen nutzt und mit Begriffen, die nicht bestimmten Normen entsprechen. Dies liegt daran, dass die gelernte Information in LLMs bewusst unkonkret und mehrdeutig gehalten ist

So "weiß" ein LLM z.B., dass ein Fenster in einer Beziehung zu einer Wand steht. Wie genau diese Beziehung aussieht ist aber unbestimmt. Die konkrete Angabe ist aber nötig, um später automatisch ein Simulationsmodell aufbauen zu können. So könnte die Wand beispielsweise mehrere (1-n) Öffnungen enthalten, in die Fenster eingesetzt sind, oder die Wand selbst besteht aus Fensterelementen.

Die Fenster müssen zudem bestimmten (ggf. impliziten) Anforderungen genügen, beispielsweise:
- sind aus Sicherheitsglas,
- öffnen nach innen,
- haben eine bestimmte Brüstungshöhe.

Auch diese Informationen sind dem LLM bekannt, werden aber nicht mit der ursprünglichen Aufgabe in Verbindung gebracht, wenn sie nicht explizit mit einbezogen werden.

Es ist daher Aufgabe der Erfindung, ein automatisches System vorzuschlagen, mit dem die vom LLM erzeugte, textuelle Information schrittweise verfeinert und ergänzt werden, um automatisch daraus ein Simulationsmodell zu generieren.

Diese Aufgabe wird gelöst durch ein Verfahren gemäß den Merkmalen des Patentanspruchs 1. Diese Aufgabe wird weiterhin gelöst durch ein Computerprogrammprodukt gemäß den Merkmalen des Patentanspruchs 9 und eine Vorrichtung gemäß den Merkmalen des Patentanspruchs 10.

Weitere Ausführungsbeispiele werden durch die Unteransprüche angegeben.

Ein geeignetes Mittel zur Lösung sind Standards oder genauer gesagt die Ontologien, die in vielen Standards wie den oben bereits zitierten IFC, DEXPI ... enthalten sind. Hier wird genau definiert, welche Elemente in dem Text mindestens enthalten sein müssen (Entitäten) und wie genau ihre Beziehungen benannt sein müssen ("ist enthalten", "ist verbunden mit", "ist vom Typ" ...).

Der wesentliche Unterschied zu bekannten Lösungen (z. B. der Produktion von XML-Modellen per LLMs) ist also die Verwendung eines sogenannten "Refinement"-Moduls, das schrittweise die ursprüngliche, ungenaue Ausgabe des Modells verbessert, bis ein Stand erreicht ist, der den Vorgaben eines (oder mehrerer) Standards genügt und somit zur Erzeugung von Modellen geeignet ist.

Die Erfindung wird im Folgenden auch durch Ausführungsbeispiele erläutert. Dabei werden durch die Figuren dargestellt:
- Figur 1: die Verwendung eines Refinement-Moduls
- Figur 2: die Verwendung von LLM zur Extraktion von Wissen
- Figur 3: eine verbesserte Verwendung zur Modellerstellung
- Figur 4: Refinement Modell Plugin
- Figur 5: Beispiel für einen Knowledge Graph
- Figur 6: der Knowledge Graph und IFC Standard

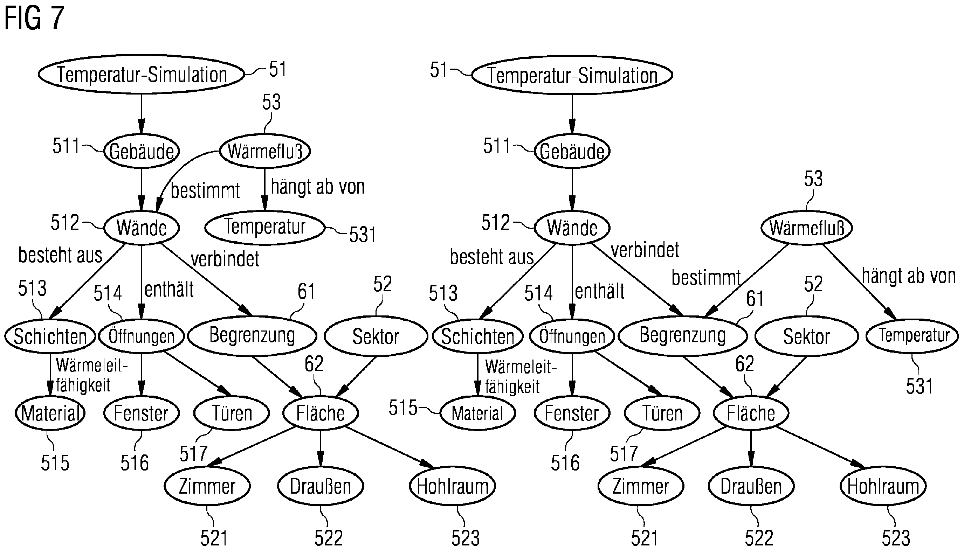

- Figur 7: Strukturvergleich von Knowledge Graphen
- Figur 8: Beschreibung eines Industrieroboter gemäß URDF Standard
- Figur 9: ein Ablaufdiagramm, gemäß dem Stand der Technik.

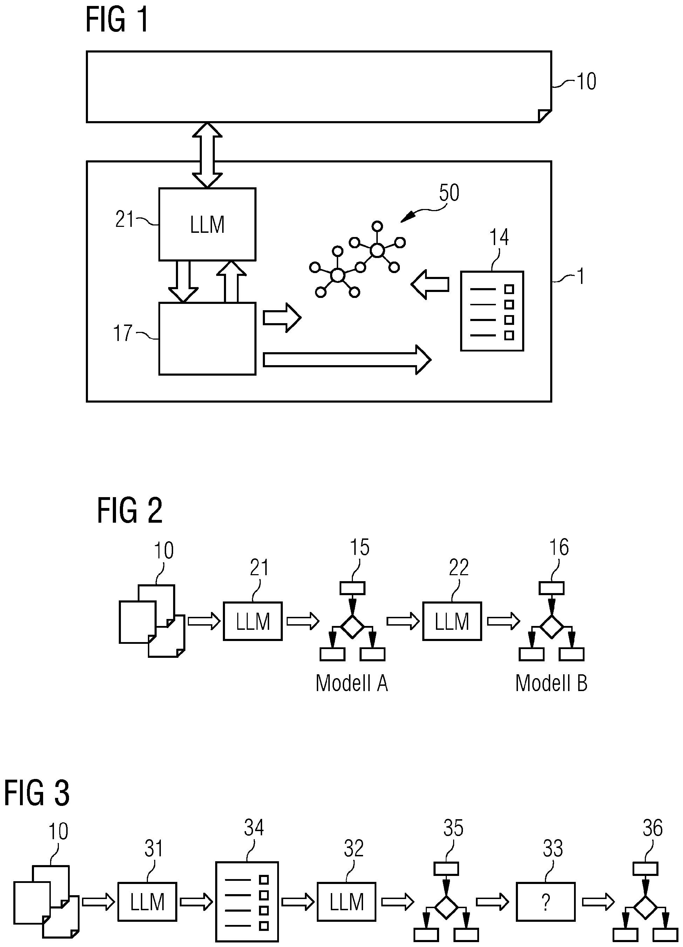

Wie in Figur 1 gezeigt, wird dafür ein Large Language Modell LLM verwendet, das speziell auf die Generierung von Abfragen aus der textuellen Modellbeschreibung trainiert ist. Für diese Abfragen kann beispielsweise die Sprache SparQL verwendet werden, eine graphenbasierte Abfragesprache für Abfragen von Inhalten aus dem Beschreibungssystem Resource Description Framework (RDF), die in Datenbanken zur Formulierung logischer Aussagen über beliebige Dinge genutzt wird. Über ein Plug-In (z. B. https://openai.com/blog/chatgpt-plugins für Chat-GPT) kann es dann auf die Ontologien angewandt werden, die Informationen zum vorliegenden Standard enthalten. Unter einer Ontologie versteht man in der Informatik sprachlich gefasste und formal geordnete Darstellungen einer Menge von Begriffen und der zwischen ihnen bestehenden Beziehungen in einem bestimmten Gegenstandsbereich. Sie werden dazu genutzt, "Wissen" in digitalisierter und formaler Form zwischen Prozessen (oft Anwendungsprogrammen) und Diensten auszutauschen.

Für eine SparQL-Abfrage werden die Ontologien im RDF Format abgelegt. Die entsprechende Ontologie ist entweder direkt im Standard hinterlegt (z. B. ifcOWL - Web Ontology Language (OWL) representation of the Industry Foundation Classes (IFC) schema) oder kann relativ leicht daraus erzeugt werden.

Zur Lösung dieses Problems bieten Large Language Models (LLMs) interessante Fähigkeiten. Die gewünschte Anwendung ist in der Figur 2 schematisch dargestellt. Durch LLMs 21, 22 kann das textuell formulierte Wissen aus Anforderungslisten 10 oder aus ersten Modellen 15 extrahiert und auf andere Softwarekomponenten oder zweite Modelle 16 übertragen werden, ähnlich wie eine textuelle bzw. mündliche Übertragung von Wissen von Mensch zu Mensch erfolgt.

Bei idealer Funktionsweise und Anwendung könnten so Modelle verlustfrei und ohne den Zwischenschritt über einen Standard von einer Softwarekomponente (bzw. aus Anforderungen) auf eine andere übertragen werden.

Zu einer Verbesserung der Modellerstellung und Transformation durch LLMs soll das Verfahren daher in folgende, unabhängige Schritte zerlegt werden:
In Schritt 1 soll die Ausgangsinformation zu Anforderungen (Requirements, bestehende Modelle, Templates) zunächst in eine eindeutige, vollständige, normierte Textform überführt werden. Dieser Schritt 1 soll im Folgenden näher betrachtet werden.

In einem nachfolgenden Schritt 2 wird die textuelle Beschreibung dann in ein topologisches Modell überführt (d. h. ohne Geometrie). Für Schritt 2 sind bereits Lösungen bekannt, z. B. das Simcenter Amesim-Plugln in ChatGPT). Auf den Schritt 2 kann gegebenenfalls verzichtet werden, bzw. kann dieses Problem wohl auch in Zukunft nicht mit LLMs gelöst werden, sondern es sind andere Technologien besser geeignet (z.B. Generative Adversarial Networks - GANs).

Ein Beispiel für die Umsetzung wäre das in Schritt 2) erzeugte Amesim Modell (als 2D Graph) noch strukturiert mit möglichst wenigen Kreuzungen darzustellen. Dies ist aber nur ein Vorteil für den menschlichen Nutzer, während die generelle Methodik eher für die Maschine-Maschine Kommunikation ohne Rückgriff auf Standards genutzt werden kann. Daher soll im Folgenden nur Schritt 1) betrachtet werden und wie eine automatische Lösung dieses Problems aussehen kann.

Das Large Language Model LLM greift nicht nur auf die notwendigerweise unvollständige Beschreibung in den Ausgangsinformation zu Anforderungen (Requirements) zurück, sondern auf die gesamte in ihm abgespeicherte Information (z. B. zur Festlegung der Beziehungen, da diese in den Requirements i.d.R. nicht mehr ausdrücklich festgelegt wird, dass ein Gebäude aus Wänden besteht, was eine Wand ist, usw....). Diese Beschreibung enthält nun mehrdeutige oder unvollständige Informationen, die nun schrittweise aufgelöst werden, indem durch das System in dem Ausführungsbeispiel von dem Gebäude ein Abgleich mit dem IFC Standard erfolgt.

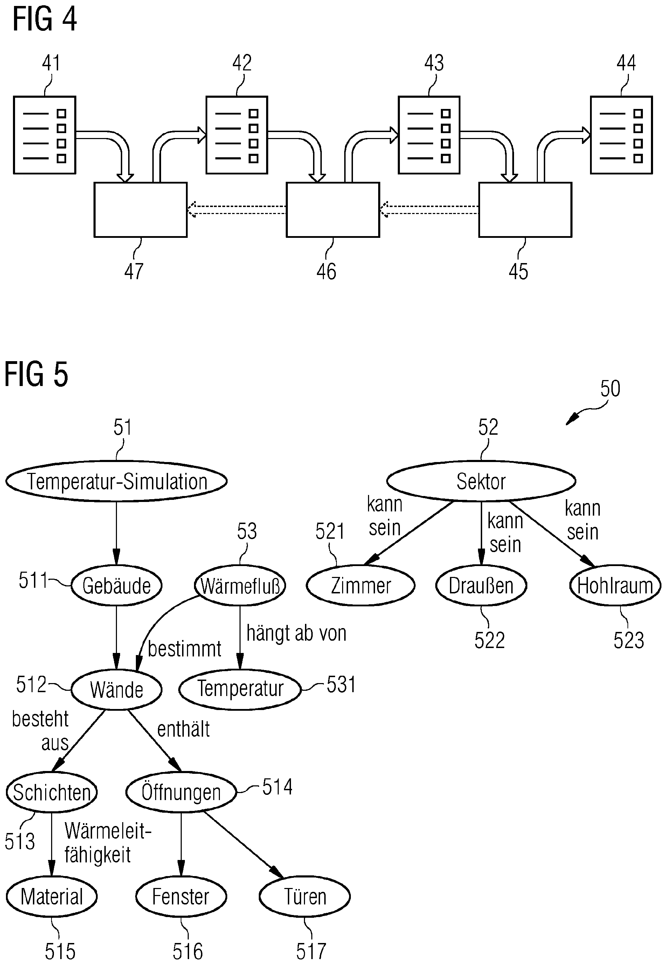

Figur 4 zeigt beispielhaft den Ablauf des Verfahrens. Dafür werden Module 45. 46, 47 benötigt, die die im vom LLM erzeugte Information automatisch bzgl. bestimmter Aspekte mit einem Standard abgleichen und eine verbesserte Version des Texts produzieren. Dies erfolgt wiederum durch ein spezielles LLM mit dem der Zugriff auf den Standard mit Hilfe eines Plug-Ins ermöglicht wird ("refinement module"):
Damit kann geprüft werden:
- Vollständigkeit: sind alle nötigen Elemente vorhanden, 47,
- Beziehungen: sind die Elemente korrekt verknüpft, 46 und
- Normalisierung

Die Änderung oder Einführung von Verknüpfungen / Beziehungen erfordert ggf. die Änderung / Einführung neuer Elemente (Rückwärtspfeil). Abschließend wird noch lokal überprüft ob bestimmte Normierungen eingehalten werden (Nomenklatur, SI-Einheiten, reguläre Ausdrücke für Bezeichner etc.)
Als Beispiel soll die oben erwähnte Konfiguration für eine Mauer herangezogen werden. Zunächst werden alle in einer Simulationsbeschreibung enthaltenen Elemente aufgelistet und in Beziehung zueinander gebracht (knowledge graph). Die Darstellung der Knowledge Graphen ist in Figur 5 enthalten. Der rechte Baum 50 enthält eine Definition gemäß dem Standard.

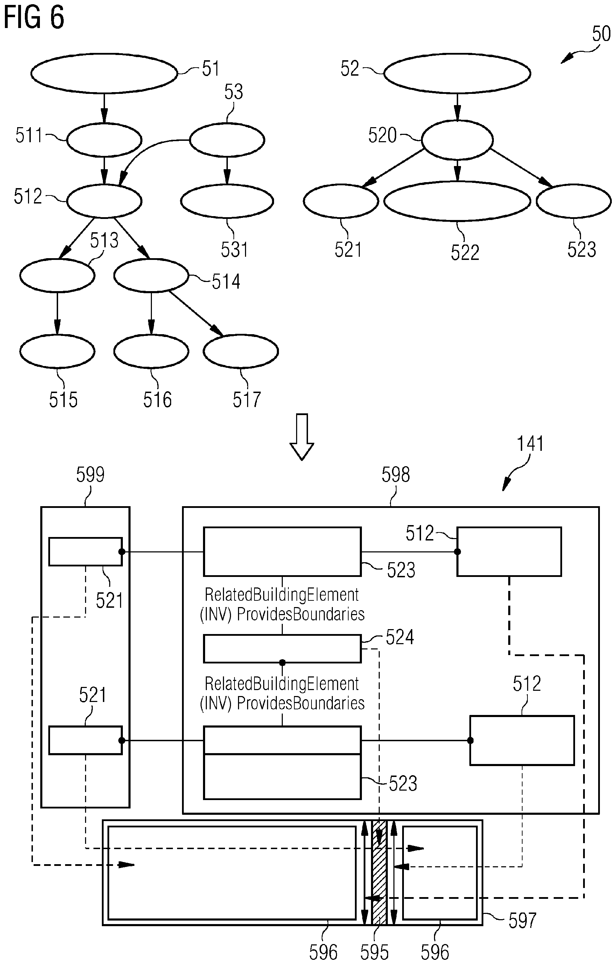

Der IFC-Standard enthält die Angabe, dass für eine Simulation "Compartments" 52 (Sektor) in "Spaces" (Zimmer) 520 zerlegt werden müssen, siehe Figur 6, Graph 50. Die in den Anforderungen (Requirements) gemachten Angaben ("Zimmer", "Hohlraum", ...) sind nur (für die Simulation unwichtige) Ausprägungen 521, 522, 523 davon. Die Beziehung in diesem Graph 50 ist jeweils "kann bestehen aus".

Weiterhin fällt auf, dass die Repräsentation aus zwei Teilgraphen 51, 52 besteht, d. h. es fehlt mindestens noch eine Beziehung, um diese zu verbinden.

Im Beispiel der Figur 5 und 6 ist der zweite Graph 51 eine Temperatur-Simulation, welche zum einen das zu simulierende Gebäude 511 und zum anderen den darin herrschenden Wärmefluß 53 betrachtet. Der Graph zum Gebäude weist weitere Informationen über den Aufbau (Wände, 512, Öffnungen, 514 etc.) und die Beschaffenheit (Material 515, Fenster, 516, ...) auf.

Die Verbindung der beiden Graphen erfolgt im nächsten Schritt unter Verwendung der rechts im Graphen angegebenen Ontologie, die im vorgegebenen Beispiel aus dem IFC-Standard genommen wird. Diese Ontologie kann in der praktischen Umsetzung beispielsweise über das Plug-In mittels einer SparQL-Query abgefragt und mit den bestehenden Entitäten verglichen werden:
"Ermittle alle Beziehungen aus der IFC-Ontologie, die Elemente im bestehenden Eingabegraph verbinden (ggf. über Elemente hinweg, die noch nicht in der Eingabe vorhanden sind - aber im Standard)".

Diese SparQL-Query wird durch das im "Refinement"-Modul enthaltene LLM erzeugt (s. u. - nicht durch das ursprüngliche LLM). D.h. das im Modul enthaltene LLM kann speziell auf diese Aufgabe (Erstellung der o.g. SparQL Queries) trainiert werden. Neben einem Vergleich der Entitäten zwischen erzeugtem Text und der Ontologie erfolgt auf Namensähnlichkeit, wäre aber auch aufgrund von Strukturvergleich des Graphen möglich (aber komplizierter und ggf. mehrdeutig).

Die Verbindung der Teilgraphen erfolgt hier durch die Einführung der im Standard festgelegten Verbindung von Wänden 512, und Räumen 62 (d.h. für eine Wand wird angegeben welche Freibereiche sie begrenzt). Hier sieht man, dass dies über die Einführung eines weiteren Elements erfolgen muss ("SpaceBoundaries"), das auch in den Anforderungen / Requirements noch nicht bekannt war. Dadurch wird der Status in diesem Fall zurück auf den vorherigen Schritt gesetzt. Die nochmalige Überprüfung der Verbindungen ergibt, dass der Wärmefluss 53 nicht mit der Wand direkt verbunden wird (wie in den Requirements angegeben), sondern mit den SpaceBoundaries 61.

Im letzten Schritt ("Normierung") haben sich in dem gewählten Beispiel keine Änderungen ergeben. Ein einfaches Beispiel für eine solche Änderung wäre die Angabe der Temperatur in Fahrenheit für den US-Markt. Die so erzeugte textuelle Information ist nun vollständig (zumindest gemäß dem ausgewählten Standard) und kann für die weitere Bearbeitung (Erzeugung von Modellen) abgespeichert werden.

Als Anmerkung sei hier erwähnt, dass durchaus auch die Verwendung von mehreren Standards möglich und sinnvoll wäre. So kann die textuelle Information dahingehend geändert werden, dass es verschieden benannte Beziehungen zwischen den gleichen Elementen gibt, oder Elemente doppelt (mehrfach) mit verschiedenen Namen auftreten.

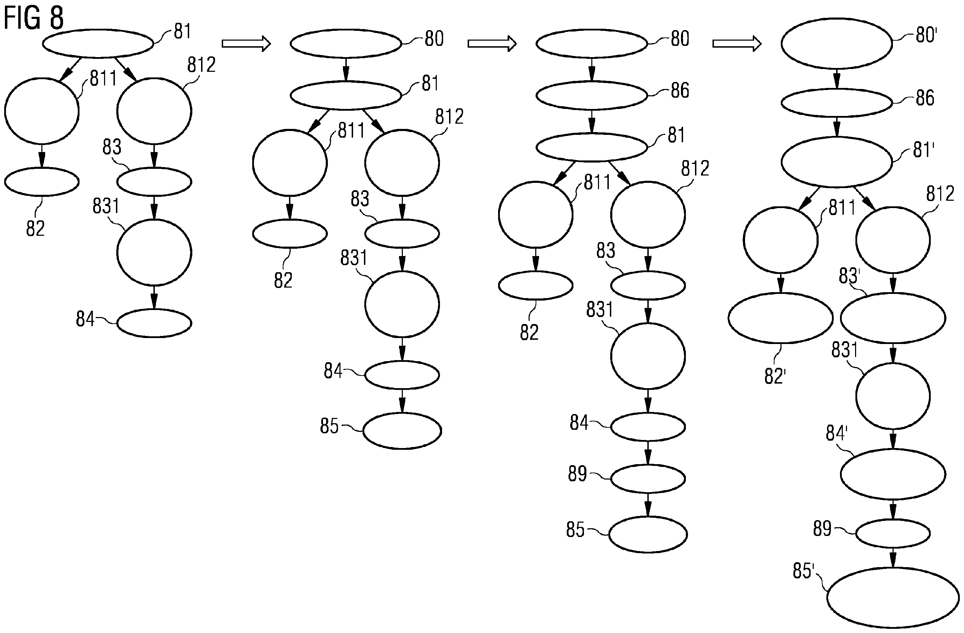

Ein weiteres Beispiel für die Anwendung des erfindungsgemäßen Verfahrens ist die Definition eines Industrieroboters, der sowohl dem URDF-Standard (Unified Robot Description Format, ein XML-Format zur Darstellung eines Robotermodells) entsprechen soll als auch den standardisierten Voraussetzungen für eine proprietäre Simulation (z.B. mit Simcenter) genügen muss. Das Beispiel ist in der Figur 8 dargestellt.

Der erste Graph links entspricht der Basisbeschreibung, die mit einem LLM (ChatGPT) aus einem URDF Standard-konformen File aus den Anforderungen / Requirements erzeugt wurde. Link1, 81 ist der Elternknoten von "joint1", 811 und "joint2", 812. Weitere Links 2, 3 und 4, 82, 83, 84 und Joints3, 831 werden entsprechend zu einem Graphen aufgebaut. Hier handelt es sich in diesem Beispiel konkret um eine Baumstruktur, mit entsprechenden Eltern - Kind Beziehungen.

Die Struktur ist aber auch abhängig von der Art des Standards.

In einem ersten Schritt wird nun eine standardisierte Beschreibung des Simulations-Tools herangezogen: diese verlangt den Befestigungspunkt des Roboters (Base), 80 und das frei bewegliche Ende ("end effector"), 85 gesondert auszuzeichnen. Dies führt aber nun dazu, dass der Roboter nicht mehr kompatibel zur URDF-Ontologie ist, die keine direkte Verbindung von Roboter-Gliedern zulässt, sondern eine Verbindung über ein Gelenk verlangt. Diese wird nun als zusätzliche Relation eingeführt, ("fixed joint") 86, 89.

Danach wird das Ergebnis nochmals gegen den Simulation-Standard geprüft, ob das System nun den dort hinterlegten Vorgaben entspricht. Das heißt vor allem, bei der Beteiligung mehrerer Standards muss über die Schritte so lange iteriert werden, bis alle Standards erfüllt sind. Dies sollte immer möglich sein, sofern die Standards widerspruchsfrei sind. Da eine Widerspruchsfreiheit schwer zu überprüfen ist, wird das Verfahren abgebrochen, wenn nach einer vorgegebenen Anzahl an Iterationen noch immer kein Konsens zwischen den Standards herbeigeführt wurde.

In einem letzten Schritt, siehe der Baum ganz rechts in der Figur 8, wird in einem Normierungsschritt ein Verweis auf die CAD-Daten eingefügt, wie sie wiederum der Simulations-Standard verlangt (zur Berechnung der Schwerpunkte, Massen etc.). Der Normierungsschritt kann i.d.R. unabhängig für jeden beteiligten Standard ausgeführt werden, da die topologische Struktur des Graphen nicht geändert wird, sondern nur die Parameter der Knoten. Im Zweifelsfall wird hierzu auch keine Widerspruchsfreiheit verlangt, da widersprüchliche Parameter standardspezifisch vermerkt (bzw. ignoriert) werden können: z.B. können [unit (std 1) = inch], [unit (std 2) = meter] als Parameter unabhängig aufgelistet werden.

## Patentansprüche

1. Computerimplementiertes Verfahren zur Bereitstellung von Simulationsdaten für eine industrielle Anlage, mit folgenden Schritten;
a) Einlesen von Ausgangsinformationen in Form einer text-basierten Anforderungsbeschreibung (10) und / oder eines Modells (15, 35),
b) Verwenden zumindest eines Standards (14) und der darin festgelegten Ontologien (50) zur Beschreibung von in der Anlage benötigten Entitäten und Beziehungen der Entitäten zueinander,
c) Übersetzen (LLM) der ermittelten Ausgangsinformation der Anforderungsbeschreibung aus Schritt a) unter Verwendung weiterer, vorbekannter Information und der Informationen aus Schritt b), als Zwischenergebnis in einen eindeutigen und normierten Text zur Beschreibung des Modells,
d) Übersetzen des Zwischenergebnis-Texts in ein topologisches Modell und daraus
e) Erzeugen eines lauffähigen topologischen Simulationsmodells.

2. Verfahren zur Bereitstellung von Simulationsdaten für eine industrielle Anlage gemäß Patentanspruch 1, **dadurch gekennzeichnet, dass**
für die Umsetzung der Ausgangsinformationen die Informationen aus zumindest zwei verschiedenen Standards verwendet werden.

3. Verfahren zur Bereitstellung von Simulationsdaten für eine industrielle Anlage gemäß Patentanspruch 1 oder 2, **dadurch gekennzeichnet, dass**
das Verfahren iterativ ausgeführt wird, also nach dem Schritt c) überprüft wird, ob das Ergebnis bereits alle Anforderungen erfüllt und ansonsten die Schritte b) und c) wiederholt werden.

4. Verfahren zur Bereitstellung von Simulationsdaten für eine industrielle Anlage gemäß Patentanspruch 3, **dadurch gekennzeichnet, dass**
nach einer vorgegebenen Anzahl von Iterationen das Verfahren abgebrochen wird, wenn noch kein eindeutiger Text erzeugt werden konnte.

5. Verfahren zur Bereitstellung von Simulationsdaten für eine industrielle Anlage gemäß einem der vorherigen Patentansprüche, **dadurch gekennzeichnet, dass**
der eindeutige und normierten Text zur Beschreibung des Modells folgende Voraussetzungen erfüllen muss:
a) eine Vollständige Beschreibung, mit allen Entitäten der Anlage (47)
b) wobei die Entitäten korrekt verknüpft sind (46), und
c) die Ausgabe normalisiert (45) ist.

6. Verfahren zur Bereitstellung von Simulationsdaten für eine industrielle Anlage gemäß einem der vorherigen Patentansprüche, **dadurch gekennzeichnet, dass**
die Informationen jeweils in Form von Knowledge Graphen (50) hinterlegt sind.

7. Verfahren zur Bereitstellung von Simulationsdaten für eine industrielle Anlage gemäß einem der vorherigen Patentansprüche, **dadurch gekennzeichnet, dass**
die Sprache SparQL als Querysprache zur Abfrage von Inhalten aus den Standards (14) und Ontologien (50) verwendet wird.

8. Verfahren zur Bereitstellung von Simulationsdaten für eine industrielle Anlage gemäß einem der vorherigen Patentansprüche, **dadurch gekennzeichnet, dass**
im Schritt c durchgeführte Normierungsschritt ein Verweis auf die CAD-Daten passend zum verwendeten Standard - Knotenparameter enthält.

9. Computerprogrammprodukt, geeignet zur Durchführung der Schritte des Verfahrens gemäß einem der Patentansprüche 1 bis 8.

10. Vorrichtung zur Bereitstellung von Simulationsdaten für eine industrielle Anlage (1);
a) Mit einer Schnittstelle zum Einlesen von Ausgangsinformationen in Form einer text-basierten Anforderungsbeschreibung (10) und / oder eines Modells (15, 35),
b) Mit Speichermitteln zum Zurverfügungstellen zumindest eines Standards (14) und der darin festgelegten Ontologien (50) zur Beschreibung von in der Anlage benötigten Entitäten und Beziehungen der Entitäten zueinander,
c) Mit einem Übersetzungsmodul (LLM) zur Übersetzung der Ausgangsinformation der Anforderungsbeschreibung unter Verwendung weiterer, vorbekannter Information und der Informationen den in den Speichermitteln erhaltenen Standardinformationen als Zwischenergebnis in einen eindeutigen und normierten Text zur Beschreibung des Modells, und Übersetzen des Zwischenergebnis-Texts in ein topologisches Modell und daraus
d) Erzeugen und Ausgabe eines lauffähigen topologischen Simulationsmodells.

11. Vorrichtung zur Bereitstellung von Simulationsdaten für eine industrielle Anlage gemäß Patentanspruch 10, **dadurch gekennzeichnet, dass**
für die Umsetzung der Ausgangsinformationen die Informationen aus zumindest zwei verschiedenen Standards verwendet werden.

12. Vorrichtung zur Bereitstellung von Simulationsdaten für eine industrielle Anlage (1) gemäß einem der Patentansprüche 10 oder 11, **dadurch gekennzeichnet, dass** Der erzeugte eindeutige und normierten Text zur Beschreibung des Modells folgende Voraussetzungen erfüllen muss:
a) eine Vollständige Beschreibung, mit allen Entitäten der Anlage (47)
b) wobei die Entitäten korrekt verknüpft sind (46), und
c) die Ausgabe normalisiert (45) ist.

13. Vorrichtung zur Bereitstellung von Simulationsdaten für eine industrielle Anlage (1) gemäß einem der vorherigen Patentansprüche 10 bis 12, **dadurch gekennzeichnet, dass** die Informationen jeweils in Form von Knowledge Graphen (50) hinterlegt sind.

14. Vorrichtung zur Bereitstellung von Simulationsdaten für eine industrielle Anlage (1) gemäß einem der vorherigen Patentansprüche 10 bis 13, **dadurch gekennzeichnet, dass** die Sprache SparQL als Querysprache zur Abfrage von Inhalten aus den Standards (14) und Ontologien (50) verwendet wird.

15. Vorrichtung zur Bereitstellung von Simulationsdaten für eine industrielle Anlage (1) gemäß einem der vorherigen Patentansprüche 10 bis 14, **dadurch gekennzeichnet, dass** im Schritt c durchgeführte Normierungsschritt ein Verweis auf die CAD-Daten passend zum verwendeten Standard - Knotenparameter enthält.
